# EUROPÄISCHE PATENTSCHRIFT

(11) **EP 0 978 419 B1**
(45) Veröffentlichungstag und Bekanntmachung des Hinweises auf die Patenterteilung: **26.02.2003**
(21) Anmeldenummer: 99112499.1
(22) Anmeldetag: 01.07.1999
(51) Int. Cl.: B60R 11/02

(54) **Gehäuse**
Casing
Boitier

(30) Priorität: 07.08.1998 DE 19835716
(43) Veröffentlichungstag der Anmeldung: 09.02.2000
(73) Patentinhaber: ROBERT BOSCH GMBH, 70442 Stuttgart (DE)
(72) Erfinder: Black, Karl-Heinz, 31139 Hildesheim (DE); Rychlak, Stefan, 31241 Ilsede (DE)

(56) Entgegenhaltungen:
- DE-A- 4 233 567
- US-A- 4 047 686
- US-A- 4 085 369
- PATENT ABSTRACTS OF JAPAN vol. 010, no. 122 (M-476), 7. Mai 1986 (1986-05-07) & JP 60 252040 A (MITSUBISHI DENKI KK), 12. Dezember 1985 (1985-12-12)

## Beschreibung

### Stand der Technik

Die Erfindung betrifft ein Gehäuse für ein in einem Fahrzeug installiertes Gerät gemäß den Oberbegriff des Anspruchs 1.

Derartige Gehäuse zur Befestigung von beispielsweise Rundfunkempfängern, Kassettenabspielgeräten, Funkgeräten und dergleichen in Fahrzeugen sind seit längerem bekannt.

Aus der DE 42 33 567 C2 geht beispielsweise eine Vorrichtung zur Montage eines in einem Fahrzeug installierten Geräts hervor, welche die Möglichkeit bietet, die Lage des Gerätes zusammen mit einem Aufnahmegehäuse in Bezug auf den Fahrzeugkörper in einem bestimmten Bereich stufenlos einzustellen. Dies wird durch ein Aufnahmegehäuse mit einer Befestigungseinrichtung für das Gerät und mit Seitenplattenteilen wenigstens an seinen beiden Seiten realisiert, wobei in jedem der Seitenplattenteile des Aufnahmegehäuses Langlöcher ausgebildet sind und ein Paar von Klemmplatten vorgesehen ist, die auf (d.h. nicht in einem Abstand zu) der Innenfläche und der Außenfläche jedes Seitenplattenteils des Aufnahmegehäuses angeordnet sind und die verschieblich ausgebildeten Seitenplattenteile zwischen sich einklemmen durch Verwendung von sich durch die Langlöcher der Seitenplattenteile und durch die Löcher der Klemmplatten erstreckenden Klemmgliedern. Wenigstens eine der paarweise angeordneten Klemmplatten wird von einem Montagebügel gestützt, der am Fahrzeug befestigt ist. Zwischen den Klemmplatten und den Seitenplattenteilen liegt kein Spalt vor.

Durch diese Befestigungsvorrichtung ist es möglich, das Gerät vor der Befestigung geringfügig zu verschieben und auf diese Weise eine optimale Lage des Geräts in bezug auf den Fahrzeugkörper zu realisieren.

Die Vorrichtung zur Montage eines in einem Fahrzeug installierten Gerätes ist dabei durch die Einbausituation und insbesondere durch die Befestigungsmöglichkeiten in einem bestimmten Fahrzeug festgelegt, sie kann nicht ohne weiteres für die Befestigung des Geräts in einem anderen Fahrzeugtyp verwendet werden.

Der Erfindung liegt nun die Aufgabe zugrunde, ein Gehäuse für ein in einem Fahrzeug installiertes Gerät dahingehend weiterzubilden, daß es auf technisch einfach zu realisierende Weise auf besonders unterschiedliche Fahrzeugtypen anpaßbar und in diesen montierbar ist.

### Vorteile der Erfindung

Diese Aufgabe wird bei einem Gehäuse für ein in einem Fahrzeug installiertes Gerät der eingangs beschriebenen Art erfindungsgemäß durch die Merkmale des Kennzeichnungsteils des Anspruchs 1 gelöst.

Durch die rückversetzten Seitenwände und die in diesem Bereich angeordneten austauschbaren Seitenbefestigungsteile kann das Gehäuse durch Anpassen der Seitenbefestigungsteile auf unterschiedliche Einbausituationen praktisch in jedem beliebigen Fahrzeug befestigt werden. Es ist dabei nicht mehr erforderlich, das gesamte Gehäuse auf unterschiedliche Einbausituationen anzupassen, es müssen vielmehr lediglich noch die Seitenbefestigungsteile auf eine vorgegebene Einbausituation, insbesondere auf ein vorgegebenes in dem Fahrzeug vorgesehenes Lochbild zur Befestigung des Geräts beispielsweise durch Schraubverbindungen angepaßt werden. Besonders vorteilhaft dabei ist es auch, daß durch das Rückversetzen des Seitenteils praktisch keine Änderungen der in dem Gerät vorgesehenen elektronischen Schaltungen vorgesehen werden müssen. Vielmehr ist es möglich, die rückversetzten Seitenwände auf optimale Weise funktional in die Schaltung, beispielsweise durch Anbindung an ein Kühlblech oder an Kühlkörper einzubeziehen.

Was die Ausbildung des Seitenbefestigungsteils betrifft, so sind die unterschiedlichsten Ausführungsformen denkbar. Eine vorteilhafte Ausführungsform sieht vor, daß in den Seitenbefestigungsteilen vorzugsweise mit Gewinde versehene Befestigungsöffnungen vorgesehen sind, die der Aufnahme von Schraubenschäften bzw. Schraubengewinden dienen.

Die Befestigung des Seitenbefestigungsteils an dem Gehäuse kann in vorteilhafter Weise durch eine Klebeverbindung und/oder eine Schraubverbindung und/oder eine Nietverbindung und/oder eine Klemmverbindung realisiert sein.

### Zeichnung

Weitere Merkmale und Vorteile der Erfindung sind Gegenstand der nachfolgenden Beschreibung sowie der zeichnerischen Darstellung eines Ausführungsbeispiels.

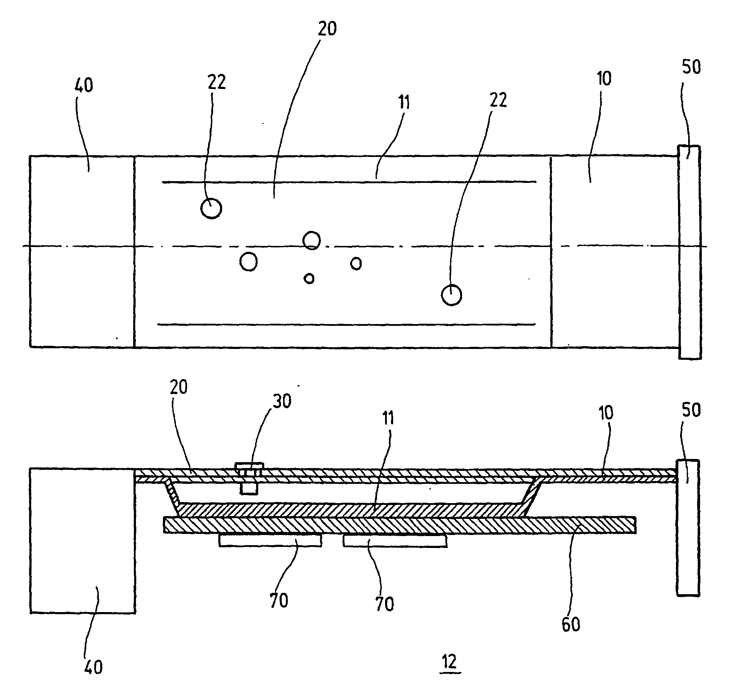

In der Figur ist eine Draufsicht sowie eine teilweise weggebrochene Seitenansicht eines erfindungsgemäßen Gehäuses dargestellt.

### Beschreibung der Ausführungsbeispiele

Ein Ausführungsbeispiel eines Gehäuses umfaßt eine nicht dargestellte Boden- und Deckenwand sowie Seitenwände, deren eine schematisch in der Figur dargestellt ist.

Wie insbesondere in der in der unteren Bildhälfte dargestellten, teilweise weggebrochenen Schnittansicht dargestellt ist, ist die Seitenwand 10 teilweise in Richtung des Gehäuseinneren 12, in dem elektronische Schaltungen und dergleichen angeordnet sind, zurückversetzt. Parallel zu einem zurückversetzten Teil 11 der Seitenwand und beabstandet von dem zurückversetzten Teil 11 der Seitenwand 10 ist ein Seitenbefestigungsteil 20 beispielsweise in Form eines Blechs an der Seitenwand 10 beispielsweise durch eine Kleb- oder Schraubverbindung befestigt.

Wie insbesondere aus der in der oberen Bildhälfte dargestellten Seitenansicht hervorgeht, sind in dem Seitenbefestigungsteil 20 Öffnungen 22 vorgesehen, die der Aufnahme von beispielsweise Befestigungsschrauben 30 zur Befestigung in einem Fahrzeug dienen. Mit der Seitenwand 10 ist ferner ein Anschlußkasten 40 sowie eine Abdeckkappe 50 verbunden, wobei in der Abdeckkappe 50 von außen zugängliche Bedienungselemente vorgesehen sind.

Wie in der Figur dargestellt, kann mit dem rückversetzten Teil 11 der Seitenwand 10 ein Kühlblech 60 einer elekronischen Schaltung verbunden sein, an welchem Endstufen 70 der elektronischen Schaltung wärmeleitend angeordnet sind.' Auf diese Weise dient die Seitenwand 10 einer vorteilhaften Wärmeableitung, in die auch das Seitenbefestigungsteil 20 einbezogen ist.

Der Vorteil der obenbeschriebenen Ausbildung der Seitenwände 10 ist darin zu sehen, daß das Seitenbefestigungsteil 20 leicht auswechselbar und auf verschiedene Einbausituationen anpaßbar ist. Insbesondere kann das Lochraster der Öffnungen 22 auf unterschiedlichste Situationen angepaßt werden.

Durch die Kombination des rückversetzten Bereichs 11 der Seitenwand 10 und des Seitenbefestigungsteils 20 ist darüber hinaus sichergestellt, daß Befestigungsschrauben 30 nicht ins Gehäuseinnere 12 gelangen und so eventuell elektrische oder elektronische Bauteile beschädigen können.

## Patentansprüche

1. Gehäuse für ein in einem Fahrzeug installiertes Gerät mit einer Boden- und Deckenwand und mit Seitenwänden (10), wobei zur Befestigung des Gehäuses in dem Fahrzeug an wenigstens zwei gegenüberliegenden Seitenwänden (10) Befestigungsmittel (30) vorgesehen sind, wobei die zur Befestigung dienenden Seitenwände (10) in Richtung des Gehäuseinneren (12) zurückversetzte Teile (11) aufweisen und wobei im Bereich der zurückversetzten Teile (11) im wesentlichen parallel zu diesen austauschbare und auf unterschiedliche Einbausituationen anpaßbare Seitenbefestigungsteile (20) lösbar befestigbar sind, **dadurch gekennzeichnet, daß** die Seitenbefestigungsteile (20) im eingebauten Zustand in einem Abstand zu den zurückversetzten Teile (11) angeordnet sind.

2. Gehäuse nach Anspruch 1, **dadurch gekennzeichnet, daß** in den Seitenbefestigungsteilen (20) vorzugsweise mit Gewinde versehene Befestigungsöffnungen (22) vorgesehen sind.

3. Gehäuse nach Anspruch 1 oder 2, **dadurch gekennzeichnet, daß** die Seitenbefestigungsteile (20) an den Seitenwänden (10) durch Klebeverbindungen und/oder Schraubverbindungen und/oder Nietverbindungen und/oder Klemmverbindungen befestigbar sind.

## Claims

1. Casing for an appliance installed in a vehicle, having a bottom wall and top wall and having side walls (10), fastening means (30) being provided on at least two opposite side walls (10), for fastening the casing in the vehicle, the side walls (10) used for the fastening having parts (11) which are set back in the direction of the casing interior (12), and side fastening parts (20) which can be exchanged essentially parallel to the set-back parts (11) and can be adapted to different installation situations being releasably fastened in the region of the said set-back parts (11), **characterized in that** in the fitted state the side fastening parts (20) are arranged at a distance from the set-back parts (11).

2. Casing according to Claim 1, **characterized in that** fastening openings (22) which are preferably provided with thread are provided in the side fastening parts (20).

3. Casing according to Claim 1 or 2, **characterized in that** the side fastening parts (20) can be fastened to the side walls (10) by bonding connections and/or screw connections and/or rivet connections and/or clamping connections.

## Revendications

1. Boîtier pour accueillir un appareil installé dans un véhicule automobile comprenant une paroi supérieure, une paroi inférieure et des parois latérales (10), avec des moyens de fixation (30) prévus sur au moins deux parois latérales opposées (10) pour fixer le boîtier sur le véhicule, et dont les parois latérales (10) servant à la fixation présentent des parties (11) reculées en direction de l'intérieur (12) du boîtier, alors que dans la zone de ces parties (11) on peut fixer de manière séparable, essentiellement parallèlement à celles-ci, des parties de fixation latérale (20) échangeables et adaptables aux situations de montage les plus diverses,
**caractérisé en ce que**
les parties de fixation latérale (20) à l'état monté se trouvent à une certaine distance des parties reculées (11).

2. Boîtier selon la revendication 1,
**caractérisé en ce que**
des ouvertures de fixation (22) portant un filetage sont prévues avantageusement dans les parties de fixation latérale (20).

3. Boîtier selon l'une quelconque des revendications 1 ou 2,
**caractérisé en ce que**
les parties de fixation latérale (20) peuvent être fixées aux parois latérales (10) par des liaisons par collage et/ou par vis et/ou par rivets et/ou par serrage.
